Europäisches Patentamt

(19) European Patent Office

Office européen des brevets

(11) Publication number: **0 000 267**
**B1**

(12) **EUROPEAN PATENT SPECIFICATION**

(45) Date of publication of patent specification: **08.07.81**

(51) Int. Cl.³: **H 01 S 3/19, H 01 S 3/06**

(21) Application number: **78300070.6**

(22) Date of filing: **22.06.78**

(54) Light source in an optical communications system.

(30) Priority: **01.07.77 GB 2766677**

(43) Date of publication of application:
**10.01.79 Bulletin 79/1**

(45) Publication of the grant of the European patent:
**08.07.81 Bulletin 81/27**

(84) Designated Contracting States:
**DE FR NL SE**

(56) References cited:
**US - A - 3 838 359**

(73) Proprietor: **THE POST OFFICE**
**23 Howland Street**
**London W1P 6HQ (GB)**

(72) Inventor: **Matthews, Michael Robert**
**20 Riverview**
**Melton Woodbridge, Suffolk (GB)**
Inventor: **Newman, David Henry**
**5 Grove Gardens**
**Woodbridge Suffolk (GB)**
Inventor: **Smith, David Robert**
**Oakburn Harrier's Walk**
**Easton Nr. Woodbridge Suffolk (GB)**
Inventor: **Steventon, Alan Geoffrey**
**East Briarwood Ipswich Road**
**Woodbridge Suffolk (GB)**

(74) Representative: **Abbott, Leonard Charles et al,**
**GILL JENNINGS & EVERY 53/64 Chancery Lane**
**London WC2A 1HN (GB)**

## Light source in an optical communications system

This invention relates to a light source in an optical communications system comprising a semiconductor laser of the double-heterostructure type having a substantially constant incremental efficiency in a region immediately above its lasing threshold. Light sources of this kind are generally known in the art. Such lasers are particularly effective as light sources in digital optical communications systems, in which light pulses representing information are transmitted through optical fibre waveguides.

The DC light output characteristics of a typical double-heterostructure semiconductor laser show that it has a low incremental efficiency in its non-lasing regime when the light is emitted by mere spontaneous emission. However, once the device reaches the threshold condition at which it begins to lase the incremental efficiency increases very sharply to give a straight line relationship between the optical flux emitted and the electrical current applied to it. In a typical device having narrow stripe geometry the optical flux emitted is in excess of 10mW when the electrical current applied to it is increased by between 20 and 50 mA above threshold value. The threshold current at which the device begins to lase is dependent upon temperature.

One of the ways in which a laser fails is by the erosion or burn-off of its facets or output faces by the optical flux emitted by the device. For a laser with uncoated facets an output optical power density of between 2 and $4 \times 10^5$ watts per square centimetre, generated continuously, causes erosion of the facets and, for a laser having stripe-geometry of width of between 10—20$\mu$m, this can occur at a power level of as low as 10mW. The laser eventually fails by slow facet erosion if it is held at these output power levels or, it may fail catastrophically if the electrical power applied to it is increased to give an optical flux output in excess of these power levels. Facet burn-off can occur as a result of uncompensated changes of the laser threshold arising from the changes of the laser temperature, and as a result of transient changes occurring in the electrical power supply to the laser.

At present, sophisticated and complex control circuits are required which take account of the temperature at which the laser is operating and any degradation of the laser and maintain the optical flux emitted by the laser at a predetermined level, for example 3mW. Such control circuits rely on feedback from the light output. The sophistication of the control circuit has to increase as the incremental efficiency of the laser is increased. It is difficult to arrange for the control circuit to respond quickly enough to compensate for transient changes in the electrical power supply. The control circuit must also be able to accommodate the supply of the driving pulses which may be fed to the laser to drive it to give a pulsed output. In view of this it is difficult to suppress completely transients that allow the optical flux to build up to an extent where damage is caused to the laser.

According to this invention a light source in an optical communications system comprises a double- heterostructure semiconductor laser having a substantially constant incremental efficiency in a region immediately above its lasing threshold which laser has within the operative area a decreasing incremental efficiency above the substantially constant region so that the lasing flux emitted by the laser has self saturating properties before catastrophic erosion of the facets of the laser occurs.

A light source in accordance with this invention is much more flexible since it has a similar incremental efficiency to existing devices when the power applied to it is in the region immediately above the threshold value of the laser, but the incremental efficiency reduces as the electrical power level is increased. Preferably the total incremental efficiency of the laser in the region immediately above the threshold is at least 12% and it may be as high as 80% or 90%.

In operational use there are several advantages in using a light source for an optical communications system in accordance with this invention. In such systems the lasers are pulsed to give an output which changes from a non-lasing output to an output which is in the lasing regime and which has sufficient intensity to overcome losses due to absorption encountered in the optical waveguide. Using a laser in accordance with this invention the driving pulses for driving the laser can be arranged to drive the laser from its non-lasing regime into its saturation region. In the saturation region the output optical power of the laser is relatively insensitive to variations in the driving current and the threshold current, and hence the temperature at which the laser is operating. Thus, over a specific operating life and temperature range the optical output power of the laser may be stabilised by a simple control circuit without the use of a complex feedback control system since the saturation effects of the laser prevent the rate of facet erosion exceeding some predetermined maximum value determined by the particular application under consideration.

The point at which the incremental efficiency of the laser changes and which corresponds to the start of the saturation region is chosen by taking into account the susceptibility of the laser to damage. Thus, it is dependent upon the cross-sectional area of active region, and hence the optical power density, and whether facet coatings have been used to increase its erosion resistance. There is no specific value of the optical power density above which slow facet erosion occurs, the rate of erosion merely being dependent on the optical power. The point at which saturation is required to occur is also arranged to take account of the acceptable degradation rate of the laser in the particular communications system under consideration. Typically, the point at which the saturation region begins corresponds to a value of emitted optical flux of a few milliwatts and for a stripe geometry laser having a $10\mu m$ stripe width and uncoated facets, this is preferably arranged to be about 3mW. After this point the incremental efficiency of the device preferably reduces to a value which is no greater than 50% of the substantially constant value, and ideally zero. It is further preferred that the substantially constant region extends from threshold until the lasing flux is in a range from 25% to 75% of the optical flux.

In a double heterostructure semiconductor laser the spatial distribution of the lasing filament in the transverse direction across the width of the optical cavity has a Gaussian distribution with the axis of the maximum intensity along the centre of the optical cavity. The optical flux within the optical cavity increases as the electrical power applied to the laser is increased and, as the applied power increases the spatial distribution of the lasing filament changes from that occurring at the start of the lasing regime.

At threshold, the transverse carrier profile across the optical cavity is peaked at its centre. The spatial transverse gain profile can be expressed as:—

$$g(x) = An(x) - B \text{ for } g(x) > C$$

and otherwise $= C$

where g is the spatial gain, and A and B are constants, C is the background absorption of the material and n(x) is the transverse carrier concentration profile. Thus, at threshold the gain is peaked at the centre of the stripe. For narrow cavity widths where the width $w < 10—15\mu m$, the gain is sharply peaked and is generally sufficient to hold the lasing filament central in the optical cavity even in the presence of small inhomogeneities in the cavity.

Above threshold, and when strong lasing occurs, the stimulated emission process depletes the concentration of carriers at the centre of the stripe and these are replenished by lateral or transverse current flow in the passive layers above the active layer and by lateral or transverse diffusion within the active region. The extent to which carrier replenishment occurs depends on the optical flux density, the resistivity of the layers bounding the active layer and the effective active region lateral diffusion length. Under situations of high bounding layer resistivity and short effective active region diffusion length, a flattening of the maximum of the carrier, and hence, of the gain profile occurs, so that the lasing filament is less well guided by the gain profile and tends to spread out in extent transversely. In this condition, since the lasing filament is less strongly guided it is more easily perturbed by inhomogeneities present in the device structure.

In a particular embodiment of the invention the laser has a stripe geometry with an effective width of the optical cavity being arranged such that, as the electrical power applied within the operative area increases the spatial distribution of the lasing filament changes, and the lasing filament approaches the edges of the optical cavity and moves into more lossy regions.

Alternatively, in another particular embodiment of the invention means defining the transverse dimension of the cavity cause the optical cavity to be non-uniform in its transverse dimension, so that as the electrical power applied within the operative area increases and the spatial distribution of the lasing filament changes, a greater proportion of the lasing filament propagates in a more lossy region of the optical cavity.

The optical cavity of the laser may be modified by modifying the configuration or properties of the active layer, or, alternatively, the configuration may be modified by governing the configuration or properties of the other layers of the laser and thereby affecting the optical cavity or the electrical pumping arrangements of the laser and hence the configuration of the optical cavity. In double-heterostructure semiconductor lasers the thickness of the active layer is typically about $0.2\mu m$. Consequently some propagation of the lasing filament takes place in the passive layers on each side of the active layer and these portions of the passive layers form part of the optical cavity of the laser. Thus by modifying these layers, particularly by modifying the real or apparent refractive index of these layers, the optical cavity of the laser may be modified. Preferably the configuration of the optical cavity is controlled by selecting the shape and arrangement of the electrodes, and the electrical pumping path of the laser by which electrical power is applied to the active region. Changing the effective shape or arrangement of the electrodes, and the electrical pumping path of the laser affects not only the distribution of charge carriers and hence the pumping arrangements but it may also affect the optical properties of the optical cavity, for example its refractive index.

This may occur as a result of the electrical potential applied, in use, or it may occur as a result of physical changes to the laser, for example their doping levels or non-uniformities introduced into the crystal lattice structure.

When a double heterostructure laser has stripe-geometry, one way of achieving this is to have electrodes arranged in stripes extending along the length of the optical cavity and perpendicular to the facets of the laser. The lateral or transverse current spread plays a significant part in determining the effective width of the optical cavity of the laser. Even if a stripe electrode had a width of only $1\mu$m then the effective width of the optical cavity would still be several $\mu$m. However, using techniques of proton or ion bombardment which are known per se and which cause damage to the lattice structure of the semiconductor and increase its electrical resistance, it is possible to reduce the effective width of the optical cavity. United States Patent No 3 838 359 illustrates the use of proton bombardment to produce the stripe geometry of a double heterostructure semiconductor laser. The proton or ion bombardment reduces the effective lateral carrier diffusion length and we have found that the deeper the bombardment into the laser, for a particular stripe width, the greater the self-saturating effects. However, for a laser to be useful as a light source in an optical communications system the light output should preferably be at least 2mW before the self-saturation effect sets in, and it is sometimes required to be as high as 5mW. We have found that the bombardment should not penetrate into the active layer if this output power is to be achieved before self-saturation. We have found that self-saturation effects are dependent upon the stripe width and on the depth of proton or ion bombardment. For the laser to be effective in a light source for an optical communications system its stripe width is preferably between 5 and $10\mu$m. For a laser having a stripe width of $5\mu$m we have found that the bombardment proximity to the active layer is preferably within a range from 0.7 to $0.2\mu$m; and, for a laser having a stripe width of $10\mu$m we have found that the bombardment proximity to the active layer is preferably within a range from 0.3 to $0.0\mu$m.

The configuration of the optical cavity may also be controlled in a non-uniform manner by introducing asymmetric bombardment profiles by inclining the laser surface to the ion or proton beam during bombardment or by selective masking on the surface of the laser. In this way, the bombardment may be deeper on one side of the optical cavity than on the other leading to an asymmetry in the configuration of the optical cavity.

When the optical cavity of the laser is non-uniform the non-uniformity is preferably introduced over a part of the cavity length and preferably the non-uniformity has the form of a branched gain region leading away from the remainder of the optical cavity. In this case there are two alternative paths for the lasing filament to follow and one is more lossy than the other. The two paths are preferably arranged so that changes in the charge carrier concentration in one path have no direct influence on the carrier concentration in the other path. When the laser includes a branched optical cavity it is arranged so that when the laser begins to lase, the lasing filament is initially present in the less lossy path of the cavity and remains following this path until the point at which the incremental efficiency changes at the start of the saturation region, i.e. the region with decreasing incremental efficiency. After this point the depletion of the charge carriers in the less lossy path is such that the number of charge carriers available in the other path provides sufficient gain to overcome the additional losses in the other path and thus further reduce the carrier depletion in the common parts of the two paths. This may lead to a reduction in the light output from the light source. The branched optical cavity may be Y-shaped, or X-shaped and thus terminate at one or both facets. Alternatively, it may be formed as a loop beside a portion of a normal stripe configuration cavity and so appear at neither facet. This latter case may be preferred in some circumstances since it increases the extinction ratio.

Rib waveguide, buried heterostructure and channelled substrate stripe lasers which are all types of double heterostructure lasers may also have the configuration of their optical cavities arranged so that they have self-saturating properties.

In a light source in accordance with this invention the laser may be coupled to an optical waveguide by a coupling lens. Alternatively, the laser may be butt coupled to an optical fibre waveguide. In a stripe-geometry double heterostructure semiconductor laser having a stripe width within a range from 20—30$\mu$m as the electrical power applied to it is increased, the axis of the maximum intensity of the lasing filament moves sideways a distance of between 1 and 2$\mu$m. When such a laser is coupled to a waveguide with a coupling lens this sideways movement of the lasing filament and the corresponding sideways movement of its output has a negligible effect on the launching efficiency and thus this form of coupling is preferred with such a laser. Alternatively, when the laser is a stripe-geometry laser with a width of approximately 5$\mu$m the sideways movement of the lasing filament is between 0.5 and 0.75$\mu$m. This sideways movement of the optical flux has little or no effect on the launching efficiency of the laser when it is butt coupled to the end of the optical waveguide and accordingly butt coupling is preferred with such lasers.

Various embodiments of light sources in accordance with this invention will now be described with reference to the accompanying drawings; in which:—

Figure 1 is an isometric view of a first example of laser for use in a light source;

Figure 2 is a graph showing the optical power output plotted against the electrical power input of the laser shown in Figure 1;

Figures 3a and b show two modifications of the laser shown in Figure 1;

Figures 4a, b and c are diagrams showing the configuration of the optical cavity in three further examples of laser; and,

Figures 5, 6 and 7 are diagrams illustrating the coupling of lasers and optical fibres to form light sources in optical communications networks.

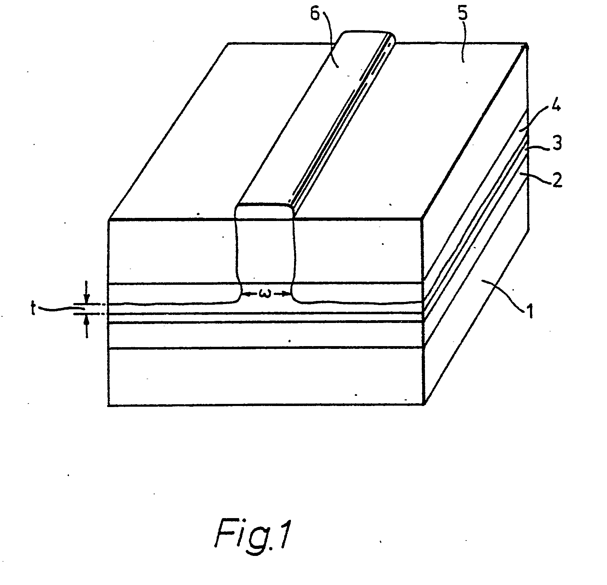

The first example of a laser was fabricated on a conventional double-heterostructure wafer having an n-type gallium arsenide substrate 1 on top of which there is a layer of n-type gallium aluminium arsenide 2, a layer of p-type gallium arsenide 3 which forms the active layer, a layer of p-type gallium aluminium arsenide 4 and finally a layer of p-type gallium arsenide 5. Figure 1 is purely a schematic diagram since the total thickness of the wafer is about $70\mu m$ whereas the thickness of the active layer 3 is approximately $0.2\mu m$, the thickness of the layer 2 is about $2\mu m$ and the thickness of each of the layers 4 and 5 is about $1\mu m$. A gold stripe 6 having a width of about $6\mu m$ was deposited on the wafer using conventional techniques and then the wafer was bombarded by protons. The proton bombardment was carried out with a Van der Graaf accelerator using $H_3^+$ ions that dissociate on the surface of the gallium arsenide into 3 equal energy protons. The wafer was first bombarded with 600eV $H_3^+$ ions at a surface density of $10^{15}$ per centimetre$^2$ and then with 400eV energy $H_3^+$ ions again at a surface density of $10^{15}$ per centimetre$^2$. The wafer was oriented with respect to the $H_3^+$ ion source by misaligning the slice by 8° to the axes of the crystal lattice structure. This ensures that the protons do not channel into the lattice structure and consequently ensures that a controlled depth of penetration is achieved.

·The protons penetrate into the parts of the layers 4 and 5 which are not protected by the gold stripe 6 and so form a damaged region indicated by the shading on Figure 1. The electrical resistance of this damaged region is very much higher than the resistance in the undamaged regions and the refractive index of the damaged regions is also effectively decreased. Some scattering of the protons that takes place within the lattice structure causes the damaged region to spread into the region beneath the gold stripe 6 as illustrated in Figure 1. In this example the width $\omega$ which is the effective stripe width of the laser is $5\mu m$. In this example the bombardment proximity t to the active layer 3 was $0.7\mu m$.

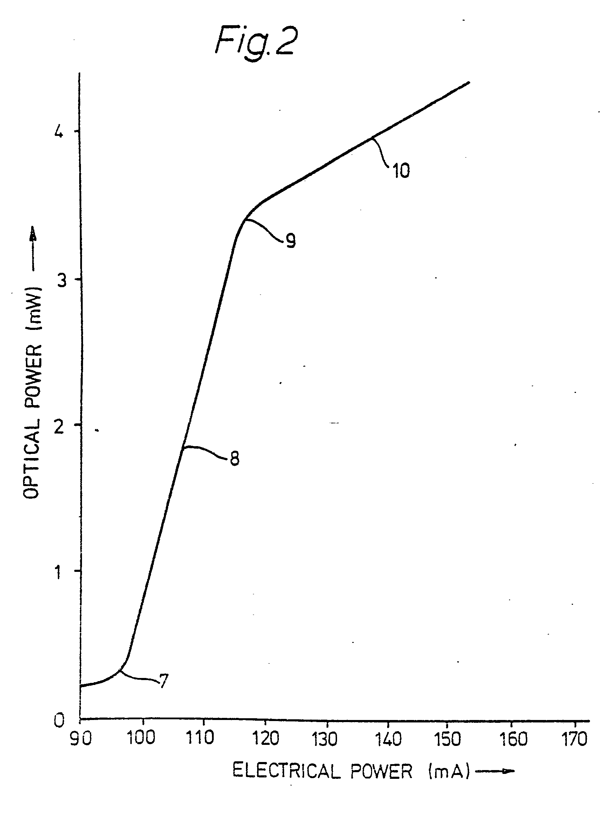

Electrical contacts were then made to the opposite sides of the wafer and the wafer was cleaved to a length of $257\mu m$. The laser than then indium bonded onto a copper header and tested. Figure 2 shows the DC light output characteristics plotted against the electrical current passing through the device. The graph clearly shows the threshold current 7 at which the transition takes place between the light emitted by spontaneous recombination and the stimulated emission of light in lasing regime 8 with substantially constant incremental efficiency. There is a straight line relationship between the electrical power supplied and the optical power output in the lasing regime 8 with substantially constant incremental efficiency until an optical power output of just over 3mW is reached as shown at point 9. From here the saturation effects can be seen with a sharp decrease in the incremental efficiency of the laser in the saturation region 10.

In operation of this laser as a light source for an optical communications network, it is pulsed from near point 7 into the saturation region 10. In the lasing region 8 an increase in the applied electrical power of about 20mA causes an increase in the optical power output of about 3mW. However, after the point 9, an increase of the applied power of about 30mA only leads to small increase, less than 1mW, in the optical power. Thus, the provision of the saturation region 10 enables the laser to be driven with a series of pulses the height of which is not critical since, even if the pulse is twice as large as necessary to drive the laser through its lasing regime 8 the optical power output is only slightly larger than that required and consequently, there is no substantial damage to the facets of the laser since the optical power does not build up to a level at which substantial damage occurs.

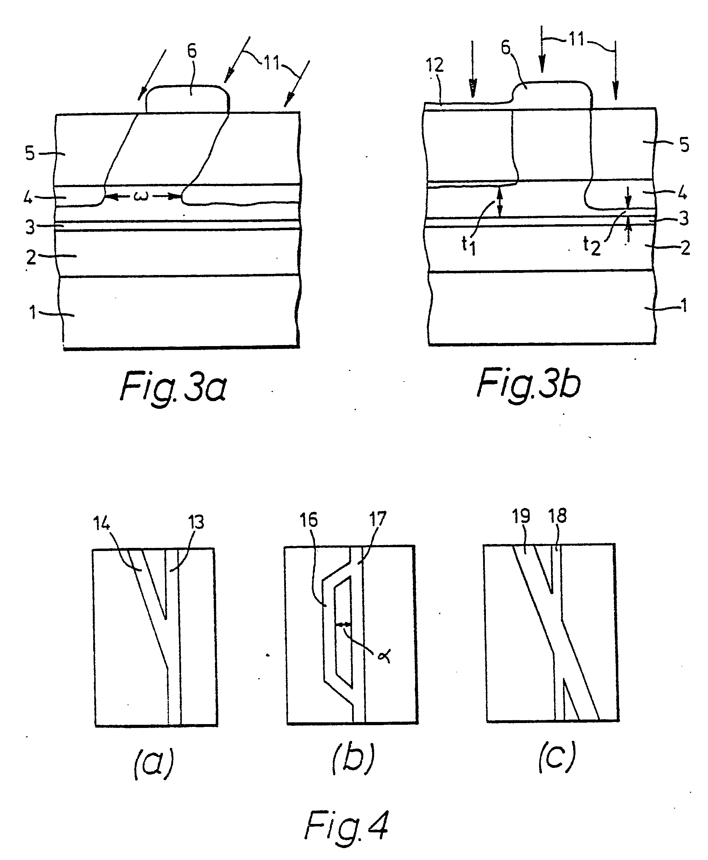

The first example may be modified by producing an asymmetric structure for the optical cavity as shown in Figures 3a or 3b. Figure 3a shows how an asymmetric structure can be achieved by inclining the wafer with respect to an incident beam of protons 11. Figure 3b shows how differential masking may be used to achieve an asymmetric structure for the optical cavity, and, in this case, a thin layer of gold 12 is deposited along one side of the stripe 6 and, this thin layer of gold 12 reduces the energy of the protons and hence reduces their penetration into the layers 4 and 5. Thus, in the modification shown in Figure 3b the bombardment proximity $t_1$ at one side of the optical cavity is very much larger than the corresponding bombardment proximity $t_2$ on the other side of the cavity.

As an alternative the laser may be arranged to have a non-uniform optical cavity and Figure 4 shows three different examples showing the configuration of the optical cavity when this is formed as a branch-gain cavity. Figure 4a shows a generally Y-shaped optical cavity and, in this example the lasing filament is initially present only in the straight limb 13 of the cavity. However, as the applied electrical power is increased and strong carrier depletion occurs immediately above the limb 13, the lasing filament spreads so that it is present in both the limb 13 and the branch limb 14. As the applied electrical power is increased still further, the lasing filament in the limb 13 suffers increased losses and the incremental efficiency of that limb decreases since an increased carrier depletion occurs in the region which is common to both limbs.

The lasing filament in the limb 14 does not meet the output facet of the laser normally and it propagates and moves over a curved path, and hence the branch 14 has a lower gain and is more lossy than the limb 13. Thus as the current is increased above the saturation point both limbs become more lossy than they were at saturation and this results in a decrease in the output optical power.

Figure 4b shows another configuration where the optical cavity has the form of a loop. A branch limb 16 of the optical cavity is arranged a distance $\alpha$ from a main limb 17. The distance $\alpha$ should preferably be at least $10\mu m$ so that depletion effects occuring in the layers above the limbs 16 and 17 are substantially independent of one another. In this example the lasing filament initially follows the main limb 17 but, as depletion sets in in the layers above the main limb 17, the lasing filament also passes round the more lossy branch limb 16. The limb 16 is more lossy because the lasing filament propagates in a curved path. As the applied electrical power increases the gain in the branch limb 16 becomes sufficient to support lasing and this depletes the common regions still further with the result that the overall efficiency decreases.

Finally, the example shown in Figure 4c has a generally X-shaped optical cavity. This X-shaped cavity is formed by a main limb 18 normal to the facets and a wider oblique limb 19. Initially, the lasing filament follows the main limb 18 but, upon depletion of the carriers in the layers above the main limb 18 a similar effect occurs as described above with reference to Figure 4a.

The optical cavities having the configurations shown in Figure 4 may be formed by conventional photolithographic techniques coupled with bombardment by protons, or other ions, insulator isolation, otherwise known as "oxide isolation" or proton junction isolation to form the outlines of the optical cavity.

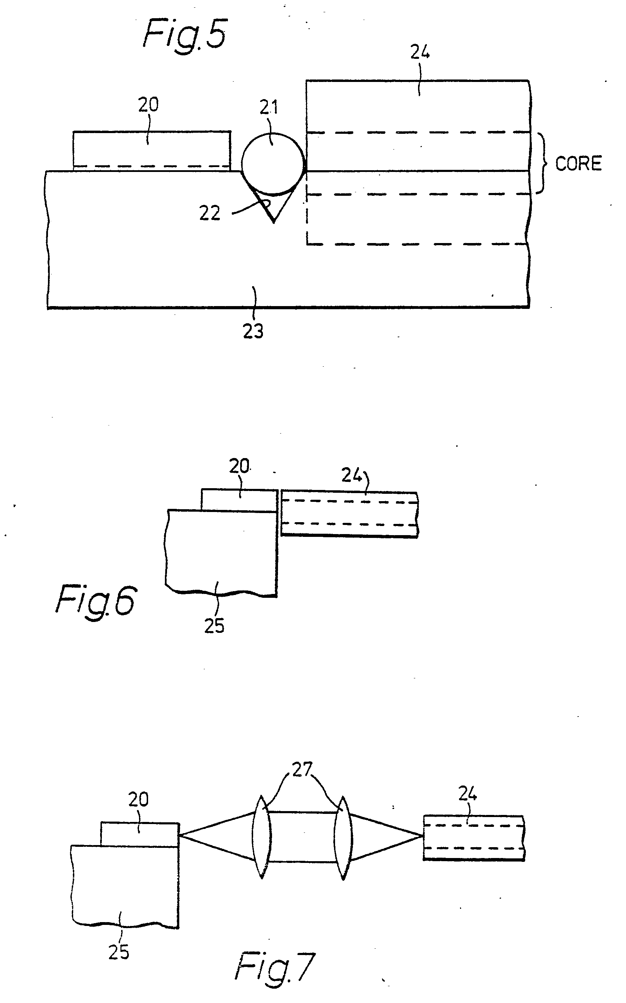

Figure 5 shows a laser light source in an optical communications network. In this Figure light from a laser 20 of one of the kinds described above is focused by a cylindrical lens 21, resting in a V-shaped groove 22 in a substrate 23, into the tail of an optical fibre 24.

In Figure 6, the laser 20 is mounted on a heat sink 25 and is butt-coupled to the fibre 24 to form the light source of the optical communications network. Finally, in Figure 7 the output of the laser 20 is coupled by a lens system 27 into the tail of the fibre 24.

**Claims**

1. A light source in an optical communications system comprising a double heterostructure semiconductor laser having a substantially constant incremental efficiency in a region immediately above its lasing threshold (7) characterised in that the laser has within the operative area a decreasing incremental efficiency (10) above the substantially constant region (8) so that the lasing flux emitted by the laser has self saturating properties before catastrophic erosion of the facets of the laser occurs.

2. A light source according to claim 1, further characterised in that within the region (10) above the substantially constant region (8) the incremental efficiency decreases to a value which is no greater than 50% of that in the substantially constant region.

3. A light source according to claim 1 or 2, further characterised in that the substantially constant region (8) extends from threshold until the lasing flux is in a range from 25 to 75% of that at which the catastrophic facet erosion of the laser occurs.

4. A light source according to any one of claims 1 to 3, characterised in that the laser has a stripe geometry with an effective width of the optical cavity being arranged such that, as the electrical power applied within the operative area increases the spatial distribution of the lasing filament changes, and the lasing filament approaches the edges of the optical cavity and moves into more lossy regions.

5. A light source according to claim 4, characterised in that the stripe geometry is produced by proton bombardment and in that the proximity of the proton bombardment to the optical cavity of the laser is a function of the stripe width, the function of the bombardment proximity to the stripe width being such that the bombardment proximity lies in a range from 0.7 microns to 0.2 microns with a stripe width of substantially 5 microns and lies in a range from 0.3 microns to 0.0 microns when the stripe width is substantially 10 microns.

6. A light source according to any one of claims 1 to 3, characterised in that means defining the transverse dimension of the optical cavity cause the optical cavity to be non-uniform in its transverse dimension, so that as the electrical power applied within the operative area increases and the spatial distribution of the lasing filament changes, a greater proportion of the lasing filament propagates in a more lossy region of the optical cavity.

7. A light source according to claim 6, characterised in that the means defining the transverse dimension of the optical cavity is introduced over at least a part of the length of the optical cavity, and in that the non-uniformity has the form of a branched gain region leading away from the remainder of the optical cavity.

8. A light source according to claim 7, characterised in that the branch optical cavity is Y-shaped, (13, 14) X-shaped (18, 19) or shaped as a loop (16) beside a portion of a normal stripe configuration cavity (17).

9. A light source in an optical communications system in accordance with any one of the preceding claims, in which the laser (20) is coupled to an optical waveguide (24) by a coupling lens (21).

10. A light source in an optical communications system in accordance with any one of claims 1 to 8, in which the laser (20) is butt coupled to an optical fibre waveguide (24 in Figure 6).

**Revendications**

1. Une source lumineuse dans un système de télécommunications optiques comprenant un laser à semiconducteur à double hétérostructure ayant un gain incrémentiel pratiquement constant dans une région située immédiatement au-dessus de son seuil laser (7), caractérisée en ce que dans la région de fonctionnement, le laser a un rendement incrémentiel décroissant (10) au-dessus de la région pratiquement constante (8), si bien que le flux laser qui est émis par le laser présente des propriétés d'auto-saturation avant que se produise une érosion catastrophique des facettes du laser.

2. Une source lumineuse selon la revendication 1, caractérisée en outre en ce que, dans la région (10) située au-dessus de la région pratiquement constante (8), le rendement incrémentiel diminue jusqu'à une valeur qui ne dépasse pas 50% de celle existant dans la région pratiquement constante.

3. Une source lumineuse selon la revendication 1 ou 2, caractérisée en outre en ce que la région pratiquement constante (8) s'étend depuis le seuil jusqu'à ce que le flux laser soit dans une plage allant de 25 à 75% de celui auquel l'érosion catastrophique des facettes du laser se produit.

4. Une source lumineuse selon l'une quelconque des revendications 1 à 3, caractérisée en ce que le laser a une géométrie en bande avec une largeur effective de la cavité optique qui est telle que, lorsque la puissance électrique appliquée dans la région de fonctionnement augmente, la distribution spatiale du filament manifestant l'effet laser change, et le filament manifestant l'effet laser s'approche des bords de la cavité optique et passe dans des régions ayant davantage de pertes.

5. Une source lumineuse selon la revendication 4, caractérisée en ce que la géométrie en bande est produite par bombardement protonique et en ce que la proximité du bombardement protonique vis-à-vis de la cavité optique du laser est une fonction de la largeur de la bande, la fonction de la proximité du bombardement vis-à-vis de la largeur de la bande étant telle que la proximité du bombardement est comprise dans une plage de 0,7 microns à 0,2 microns avec une largeur de bande pratiquement égale à 5 microns et se trouve dans une plage de 0,3 microns à 0,0 microns lorsque la largeur de bande est pratiquement égale à 10 microns.

6. Une source lumineuse selon l'une quelconque des revendications 1 à 3, caractérisée en ce que les moyens qui définissent la dimension transversale de la cavité optique font en sorte que la cavité optique ne soit pas uniforme dans sa dimension transversale, afin que, lorsque la puissance électrique appliquée, dans la région de fonctionnement, augmente et que la distribution spatiale du filament manifestant l'effet laser change, une plus grande proportion du filament manifestant l'effet laser se propage dans une région à plus fortes pertes de la cavité optique.

7. Une source lumineuse selon la revendication 6, caractérisée en ce que les moyens qui définissent la dimension transversale de la cavité optique sont introduits sur sur partie au moins de la longueur de la cavité optique, et en ce que le défaut d'uniformité a la forme d'une région de gain en dérivation s'éloignant du reste de la cavité optique.

8. Une source lumineuse selon la revendication 7, caractérisée en ce que la cavité optique à dérivation a une forme en Y (13, 14), une forme en X (18, 19) ou une forme correspondant à une boucle (16) s'ajoutant à une partie en cavité normale à configuration en bande (17).

9. Une source lumineuse dans un système de télécommunications optiques selon l'une quelconque des revendications précédentes, dans laquelle le laser (20) est couplé à un guide d'onde optique (24) par une lentille de couplage (21).

10. Une source lumineuse dans un système de télécommunications optiques selon l'une quelconque des revendications 1 à 8, caractérisée en ce que le laser (20) est couplé bout à bout à un guide d'onde à fibre optique (24 sur la figure 6).

**Patentansprüche**

1. Lichtquelle in einem optischen Nachrichtensystem mit Doppel-Heterostruktur-Halbleiter-Laser, der einen im wesentlichen konstanten inkrementalen Wirkungsgrad in einem Bereich unmittelbar oberhalb seiner Laserbetriebs-Schwelle (7) hat, dadurch gekennzeichnet, daß der Laser innerhalb des Betriebsbereichs einen abnehmenden inkrementalen Wirkungsgrad (10) oberhalb des im wesentlichen konstanten Bereichs (8) hat, so daß der vom Laser emittierte Laserlicht-Strom Selbstsättigungs-Eigenschaften vor Auftreten einer katastrophalen Erosion der Laser-Flächen zeigt.

2. Lichtquelle nach Anspruch 1, dadurch gekennzeichnet, daß innerhalb des Bereichs (10) oberhalb des im wesentlichen konstanten Bereichs (8) der inkrementale Wirkungsgrad auf einen Wert von höchstens 50% des Wirkingsgrads im im wesentlichen konstanten Bereich verringert ist.

3. Lichtquelle nach Anspruch 1 oder 2, dadurch gekennzeichnet, daß der im wesentlichen konstante Bereich (8) sich von der Schwelle erstreckt, bis der Laserlicht-Strom sich in einem Bereich von 25 bis 75% desjenigen befindet, der bei der katastrophalen Flächen-Erosion des Lasers auftritt.

4. Lichtquelle nach einem der vorhergehenden Ansprüche, dadurch gekennzeichnet, daß der Laser eine Streifen-Geometrie mit einer wirksamen Breite des optischen Resonanzraums derart hat, daß, wenn die im Betriebsbereich zugeführte elektrische Leistung zunimmt, die räumliche Verteilung der Laserlicht-Fadenstruktur sich ändert und die Laserlicht-Fadenstruktur sich den Kanten des optischen Resonanzraums nähert und sich in verlustreichere Bereiche bewegt.

5. Lichtquelle nach Anspruch 4, dadurch gekennzeichnet, daß die Streifen-Geometrie hergestellt ist durch Protonen-Beschuß, und daß die Nähe des Protonen-Beschusses zum optischen Resonanzraum des Lasers eine Funktion der Streifen-Breite ist, wobei die Beziehung der Beschuß-Nähe zur Streifen-Breite derart gewählt ist, daß die Beschuß-Nähe in einem Intervall von 0,7 $\mu$m bis 0,2 $\mu$m bei einer Streifen-Breite von ca. 5 $\mu$m und in einem Intervall von 0,3 $\mu$m bis 0,0 $\mu$m bei einer Streifen-Breite von ca. 10 $\mu$m liegt.

6. Lichtquelle nach einem der Ansprüche 1 bis 3, dadurch gekennzeichnet, daß eine die Quer-Abmessung den optischen Resonanzraums begrenzende Einrichtung den optischen Resonanzraum in Quer-Richtung ungleichmäßig macht, so daß, wenn die im Betriebsbereich zugeführt elektrische Leistung ansteigt und die räumliche Verteilung der Laserlicht-Fadenstruktur sich ändert, ein größerer Anteil der Laserlicht-Fadenstruktur sich in einen verlustreicheren Bereich des optischen Resonanzraums bewegt.

7. Lichtquelle nach Anspruch 6, dadurch gekennzeichnet, daß die Einrichtung zur Begrenzung der Quer-Abmessung des optischen Resonanzraums sich über mindestens einen Teil der Länge des optischen Resonanzraums erstreckt, und daß die Ungleichmäßigkeit die Form eines Bereichs mit verzweigter Verstärkung hat, der vom übrigen optischen Resonanzraum wegführt.

8. Lichtquelle nach Anspruch 7, dadurch gekennzeichnet, daß der verzweigte optische Resonanzraum Y-förmig (13, 14), X-förmig (18, 19) oder schleifenförmig (16) außerhalb eines Abschnitts eines Resonanzraums (17) mit normalem Streifen-Aufbau ist.

9. Lichtquelle in einem optischen Nachrichtensystem nach einem der vorhergehenden Ansprüche, wobei der Laser (20) mit einem Lichtwellenleiter (24) durch eine Koppel-Linse (21) gekoppelt ist.

10. Lichtquelle in einem optischen Nachrichtensystem nach einem der Ansprüche 1 bis 8, wobei der Laser (20) in Stumpfverbindung mit einem Faser-Lichtwellenleiter (24 in Fig. 6) steht.

Fig.1

## Fig.2

Fig.3a

Fig.3b

(a)

(b)

(c)

Fig.4

Fig.5

Fig.6

Fig.7